# EUROPEAN PATENT SPECIFICATION

(11) **EP 0 664 554 B1**
(45) Date of publication and mention of the grant of the patent: **30.12.1998**
(21) Application number: 95400143.4
(22) Date of filing: 24.01.1995
(51) Int. Cl.: H01J 5/20, H01L 31/108

(54) **Infrared radiation sensor, method of making it and use of the infrared radiation sensor**
Infrarot-Strahlungssensor, Verfahren zu seiner Herstellung und Verwendung des Infrarot-Strahlungssensors
Capteur de rayonnement infrarouge, methode de la fabrication et l'utilisation du capteur de rayonnement infrarouge

(30) Priority: 24.01.1994 JP 6003/94
(43) Date of publication of application: 26.07.1995
(73) Proprietor: TERUMO KABUSHIKI KAISHA, Tokyo (JP); Kimura, Mitsuteru, Miyagi-gun, Miyagi-ken 985 (JP)
(72) Inventor: Kimura, Mitsuteru, Miyagi-gun, Miyagi-ken (JP); Kudo, Takeshi, c/o Terumo K.K., Ashigarakami-gun, Kanagawa-ken (JP); Mori, Takehisa, c/o Terumo K.K., Ashigarakami-gun, Kanagawa-ken (JP)
(74) Representative: Joly, Jean-Jacques

(56) References cited:
- EP-A- 0 534 424
- EP-A- 0 566 156
- US-A- 4 468 685
- PATENT ABSTRACTS OF JAPAN vol. 17 no. 264 (E-1370) ,24 May 1993 & JP-A-05 006996 (NEC) 14 January 1993,
- PATENT ABSTRACTS OF JAPAN, Vol. 17, no. 329, (P-1561) & JP-A-5 040 064

## Description

### BACKGROUND OF THE INVENTION

### Field of the Invention:

This invention relates to an infrared radiation sensor for the noncontacting determination of the temperature of a given object, especially the temperature of living body's tympanic membrane.

### Description of the Prior Art:

Heretofore, it has been customary to determine the temperature of a given substance on the principle that the substance heats a thermosensitive portion through the medium of infrared radiation and the temperature of the thermosensitive portion is elevated proportionately to the extent of this heating. Various measures directed to the miniaturization of infrared radiation sensors or to the exaltation of sensitivity of infrared radiation sensors have been proposed. Particularly when the temperature of a given object approximates or surpasses normal room temperature, the available incident infrared radiation is very feeble. When a thermistor type temperature sensing means is adopted, therefore, it is necessary that the thermistor constant of the sensor be so high and, at the same time, the thermal capacity thereof be so low as to prevent the energy of the incident infrared radiation from deviation to the fullest possible extent.

For the sake of attaining the latter effect, namely for the purpose of decreasing to the fullest allowable extent the volume of the thermal energy lost from the thermosensitive portion, an idea of minimizing the transfer of heat to the ambient air by forming the thermosensitive portion on a very minute bridging portion and further furnishing the thermosensitive portion with means capable of airtightly sealing the periphery thereof in a vacuum may be conceived (see EP-A-0 566 156).

The means for sensing the infrared radiation utilizes the phenomenon that the electric resistance of a thermopile, a pyroelectric film, or a film of amorphous germanium, amorphous silicon, polycrystalline germanium, or polycrystalline silicon is varied by temperature. It is, therefore, suitable for the miniaturization of a sensor. When this means is employed, the sensor acquires a thermistor constant (B constant) of about 3500 K. For the purpose of miniaturizing an infrared radiation sensor and exalting the sensitivity of the infrared radiation sensor, however, this sensitivity cannot be regarded as sufficient.

As means for heightening the sensitivity to the infrared radiation, a sensor using a pn junction diode (JP-A-05-142,039 and Technical Digest of 9th Sensor Symposium, 1990, pp. 71-74) and a so-called Schottky junction temperature sensor (JP-A-05-40,064) have been disclosed.

The former sensor utilizes the temperature characteristic which is manifested when the pn junction diode is biased in the forward direction. The temperature coefficient of the forward voltage is -1.6 mV/°C and the sensitivity thereof is only 33 V/W. Thus this sensor is still deficient in sensitivity.

In contrast thereto, the latter sensor utilizes the phenomenon that the reverse-direction saturated current which flows when a reverse-direction voltage is applied to the Schottky junction is markedly varied by temperature. This sensor acquires a very high equivalent thermistor constant of about 7600 K. This fact implies the possibility that the sensor will acquire a sensitivity of not less than two times the sensitivity of the conventional thermistor type infrared radiation sensor. The invention covering this sensor manufactures the Schottky junction diode with a single crystal silicon substrate. For the sensor to be heated by a feeble infrared radiation, the thermal capacity is unduly large and the temperature of the diode portion is not fully elevated. Thus, this invention falls short of affording a highly sensitive infrared radiation sensor.

It is difficult to form a single crystal silicon exactly in a designed shape on a bridged structure formed by an insulated thin film.

Specifically, for the purpose of forming a semiconductor element on a bridged structure formed by an insulated thin film, use of a polycrystalline or amorphous semiconducting material may be made.

Incidentally, the Schottky junction diode is manufactured exclusively with single crystal silicon. No literature is found to report a case of using a film of amorphous material or polycrystalline material which is formed on a bridged structure.

An object of this invention, therefore, is to provide a novel infrared radiation sensor.

Another object of this invention is to provide a highly sensitive infrared radiation sensor which forms a high sensitive thermosensor at a thin film semiconductor material formed on an electrical insulating thin film and is capable of sensing even a feeble infrared radiation at a high accuracy owing to the use of an infrared sensing means having a large thermistor constant.

### SUMMARY OF THE INVENTION

The objects are accomplished by an infrared radiation sensor which comprises a sensor substrate containing a cavity and having a thermosensitive portion formed on an insulating thin film portion superposed over said cavity, said thermosensitive portion using a Schottky junction of a semiconductor or thin film material and a metallic material, wherein said thermosensitive portion is operative, in response to a bias voltage applied thereto, to produce a reverse direction current that changes in correspondence with a change of temperature at the sensor caused by infrared radiation.

The invention also concerns a method of making an infrared sensor as defined in claim 11 and the use of an infrared sensor according to claim 21.

An embodiment of this invention concerns the infrared radiation sensor, wherein the insulating thin film exhibits insulation to heat.

A further embodiment of this invention concerns the infrared radiation sensor, wherein the cavity including the thermosensitive portion is sealed in a vacuum.

A still further embodiment of this invention concerns the infrared radiation sensor, wherein the insulating thin film is shaped in a structure selected from among the bridge, the cantilever, and the diaphragm structure.

A still further embodiment of this invention concerns the infrared radiation sensor, wherein the semiconducting thin film material is a polycrystalline silicon.

A still further embodiment of this invention concerns the infrared radiation sensor, wherein the semiconducting thin film material is an amorphous silicon.

A still further embodiment of this invention concerns the infrared radiation sensor, wherein the metallic material is molybdenum.

A still further embodiment of this invention concerns the infrared radiation sensor, wherein the metallic material is molybdenum silicide.

The infrared radiation sensor of this invention is adapted to utilize the temperature characteristic of the reverse-direction saturated current of a Schottky barrier diode and, therefore, serve ideally as a thermometer for the noncontacting determination of the temperature of a given object, especially the temperature of the living body's tympanic membrane. Thus, this invention permits manufacture of infrared radiation sensors enjoying high sensitivity and high accuracy.

### BRIEF DESCRIPTION OF THE DRAWINGS

Fig. 1 is a diagram schematically illustrating the visible construction of an infrared radiation sensor as one embodiment of this invention.

Fig. 2 is a diagram schematically illustrating the state in which the visible construction of an infrared radiation sensor as one embodiment of this invention is disassembled into main component portions thereof.

Fig. 3 is a diagram schematically illustrating a partially sectioned construction of a sensor substrate having incorporated therein a diaphragm type thin film as one embodiment of the present invention.

Fig. 4 is a schematically perspective view illustrating a sensor substrate having incorporated therein a cantilever type thin film.

Fig. 5 is a simplified diagram illustrating a cross section taken through Fig. 4 along the line V-V.

Fig. 6 is a perspective view of an another embodiment of the present invention.

Fig. 7 is a schematic diagram illustrating in cross section (the cross section taken through Fig. 2 along the line VII - VII) a four-point support bridge construction of an insulating thin film superposed on a cavity formed in a sensor substrate including an infrared thermosensitive portion using a Schottky junction in the infrared radiation sensor in an embodiment of this invention.

Fig. 8 is a cross section schematically illustrating one concrete example of a front lid which corresponds to the sensor substrate including an infrared thermosensitive portion using a Schottky junction in the infrared radiation sensor of the embodiment of Fig. 7.

Fig. 9 is a cross section schematically illustrating one typical example of a glass substrate destined to serve as a rear lid which corresponds to the sensor substrate including an infrared thermosensitive portion using a Schottky junction in the infrared radiation sensor of the embodiment of Fig. 7.

Fig. 10 is a graph showing the temperature characteristic of an infrared radiation sensor manufactured as one embodiment of the present invention by assembling the sensor substrate, the junction means for a front lid and a rear lid, and the vacuum sealing means for use during the junction illustrated respectively in Fig. 7 through Fig. 9 sequentially in the order mentioned.

### EXPLANATION OF THE PREFERRED EMBODIMENT

In the infrared radiation sensor of the preferred embodiment of this invention, since the periphery of the thermosensitive portion is retained in an emptied state, preferably in a vacuumized state, the amount of the thermal energy lost from the thermosensitive portion by conduction of heat to the peripheral members and to the ambient air is minimized. As a result, the elevation of temperature of the thermosensitive portion is improved and the sensitivity of the sensor is increased prominently.

The term "vacuum" as used in the present specification means the state in which the pressure is not higher than 1.0 Torr. It is provided, however, that the effect obtained under a pressure of not higher than 0.13 Pa (≤ 0.13 Pa) (10⁻³ Torr (≦ 10⁻³ Tor)) is substantially equal to that which is obtained under a pressure of 10⁻³ Torr.

More specifically, the infrared radiation sensor of this invention is preferably so constructed as to have a cavity formed in a sensor substrate, two substantially identically shaped thermosensitive portions superposed or provided on the cavity, and one of the thermosensitive portions adapted to permit selective admission of incident infrared radiation, and the other thermosensitive portion adapted to intercept incident infrared radiation. By detecting the difference between the output of the thermosensitive portion admitting the incident infrared radiation and the output of the thermosensitive portion intercepting the incident infrared radiation, the infrared radiation sensor is enabled to determine the net amount of the infrared radiation which is freed of electrical noise and thermal disturbance.

As the sensor substrate, the semiconductor substrates of silicon, germanium, etc. are usable. It is, however, preferable to use a silicon substrate which can be procured easily and inexpensively as well, especially a single crystalline silicon substrate.

As the shape (construction) of the insulating thin film which serves to support the thermosensitive portion, the bridge construction supported at the opposite ends, the cantilever construction, the diaphragm construction, etc. are effectively adoptable. For the sake of lowering thermal capacity and, at the same time, ensuring structural stability, however, it is preferable to adopt the bridge construction adapted to be supported at four points.

As the insulating thin film which serves to support the thermosensitive portion mentioned above, thin films using such substances as silicon oxide, silicon nitride, and silicon oxynitride are effectively usable. it is, however, particularly preferable to use a thin film of silicon oxynitride. The silicon oxynitride film combines the nature of a silicon oxide film and that of a silicon nitride film and, therefore, excels in stress balance and allows the formation of a construction capable of stably supporting the thermosensitive portion. The construction having the thermosensitive portion supported by this insulating thin film can be manufactured, for example, by superposing insulating thin films as of silicon oxynitride one cach on the opposite sides of a silicon substrate, preparatorily patterning by etching one of the coated sides of the silicon substrate in the shape of a bridge, a cantilever, or a diaphragm and the other side thereof in the shape of a window of a desired size (so as to leave the portion of the thin film forming the shape of the bridge intact on one side and remove the portion thereof forming the shape of the window of the desired size on the other side), and subjecting the patterned substrate to anisotropic etching by the use of an aqueous hydrazine solution or potassium hydroxide (KOH).

Then, the thermosensitive portion which is provided on or supported by the insulating thin film superposed on the cavity contained in the sensor substrate is furnished with a Schottky junction of a polycrystalline silicon film and molybdenum or molybdenum silicide. The molding of polycrystalline silicon in the form of a film for the formation of the Schottky junction is attainable by such methods as sputtering, ion beam sputtering, or LP-CVD (low-pressure chemical vapor deposition). Among other methods mentioned above, the LP-CVD method which can produce a film comprising silicon crystals of a large diameter and exhibiting stable quality proves to be particularly preferable.

The thermosensitive portion may be formed of a Schottky junction of an amorphous silicon film and molybdenum or molybdenum silicide. In this case, the sputtering method and the PCVD (plasma CVD) method are effectively used for the molding of amorphous silicon in the form of a film. The PCVD method is used preferably, however, because it permits the impurity concentration in silicon to be controlled favorably.

For the molding of molybdenum or molybdenum silicide in the form of a film, the electron beam evaporation method and the sputtering method are effectively used. The sputtering method, however, proves to be desirable because it permits the molded film to adhere with high fastness to the underlying surface of the substrate.

The position at which the thermosensitive portion is to be formed has no particular restriction so long as it falls on the insulating thin film superposed on the cavity provided in the sensor substrate. It is allowable, for example, to provide the sensor substrate with two substantially identical cavities 2, superpose insulating thin films one each on the cavities, and dispose substantially symmetrical thermosensitive portions one each substantially at the centers of the thin films.

Then, the cavity including the thermosensitive portion can be sealed in a vacuum specifically by means of lids (front lid and rear lid) joined to the opposite sides of the sensor substrate, with one of the lids joined to one side of the sensor substrate and the other lid subsequently joined to the other side of the sensor substrate in a vacuum.

These lids may be made of either silicon substrate or glass substrate. As regards the use of these lids, it is preferable that the lid, expected to permit selective introduction of the infrared radiation to either of the pair of thermosensitive portions, be made of silicon substrate, that this silicon substrate be provided with an infrared reflecting film made of aluminum or copper, and that the infrared reflecting film be furnished at the portion thereof corresponding to the thermosensitive portion destined to admit the incident infrared radiation with a window (opening portion).

As means for joining the lids to the sensor substrate, the soldering method and the anodic fusion method are usable. Particularly when the periphery of the thermosensitive portion of the infrared radiation sensor is required to remain in a vacuum, it is necessary that either the front lid or the rear lid be joined to the sensor substrate under a vacuum by following the procedure described above in association with the means of sealing. When the lid is made of Pyrex glass (trademark designation), for example, it can be directly joined to the sensor substrate made of silicon by the anodic fusion method.

Now, this invention will be described more specifically below with reference to embodiments. It should be noted that the following embodiments are intended for illustration of this invention and are not meant to limit the invention.

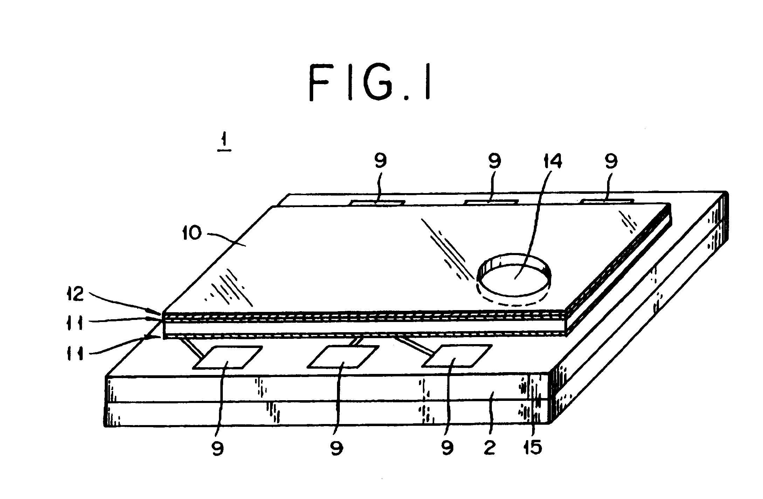

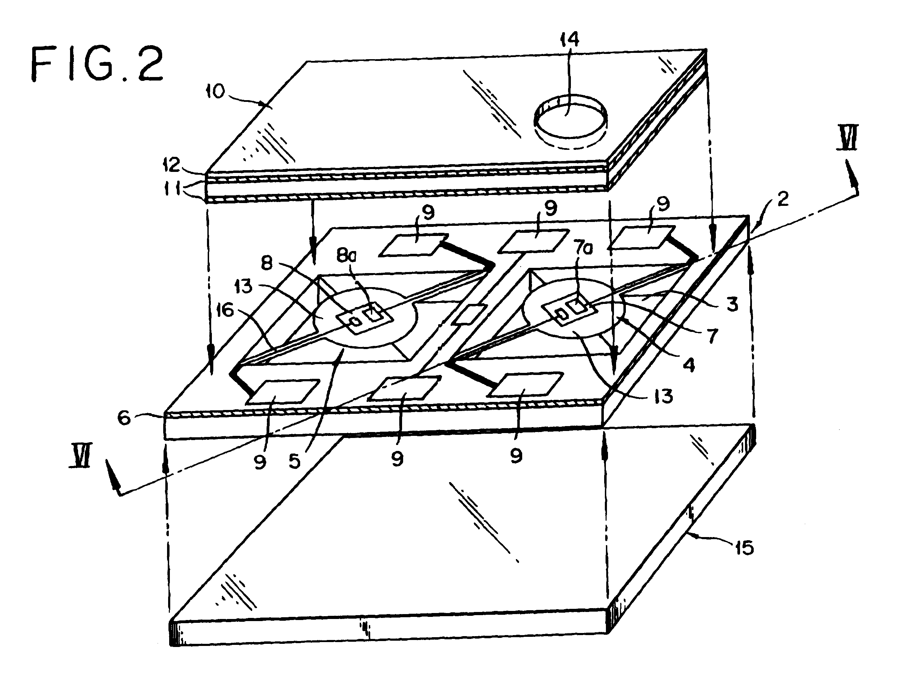

The perspective views of the constructions of an infrared radiation sensor as one embodiment of this invention are illustrated in Fig. 1 and Fig. 2.

An infrared radiation sensor 1 of the present embodiment is provided with a silicon substrate (preferably a single crystalline silicon) 2 as a sensor substrate. This silicon substrate 2 has a cavity 3 formed therein. This cavity 3 opens in the upper and the lower side of the silicon substrate 2. On the upper side of the silicon substrate 2 is formed a silicon oxynitride film 6 (thickness: 1 to 10 µm, preferably 3 µm) which is furnished with two bridge portions 4 and 5 and obtained by molding (forming) an insulating thin film superposed on the cavity 3 in a four point support bridge construction.

Thin film thermosensitive portions 7 and 8 (thickness: 0.5 to 5 µm, preferably 2 µm, size 0.2 mm × 0.4 mm to 0.4 mm × 0.8 mm) which are semiconductor material thin films are provided severally in the substantially central portions of the bridge portions 4 and 5. These thermosensitive portions 7 and 8 are formed of n-type polycrystalline silicon, for example. To the thermosensitive films 7 and 8, one-side terminal portions of electrode wiring layers which are formed of aluminum and provided with a Schottky junction 7a, 8a formed between molybdenum or molybdenum silicide and n-type polycrystalline silicon are electrically connected. The other-side terminal portions of the electrode wiring layers are extended with a chromium wire and connected to electrode pads 9 formed in the peripheral areas of the upper side of the silicon substrate 2.

On the upper side of the silicon substrate 2 is superposed the silicon oxynitride film 6. To the upper side of this silicon oxynitride film 6 is connected a front lid 10. The front lid 10 is formed of silicon and is covered with an antireflection film 11 preventing reflection of infrared radiation. On the obverse surface of the antireflection film 11, a multilayer infrared interception film 12 obtained by superposing a titanium layer on an aluminum film or a copper layer is superposed. The infrared interception film 12 is provided at the position thereof opposite an infrared receiving portion 13 with an injection window (aperture) 14 for admitting incident infrared radiation. If necessary, a Fresnel lens (not shown) may be provided or formed in the injection window 14.

To the lower side of the silicon substrate 2 is joined a rear lid 15. This rear lid 15 is made of Pyrex glass (trademark designation), for example.

This infrared radiation sensor 1 selectively admits the incident infrared radiation through the opening 14 of the front lid 10 and the cavity 3 to the thin film thermosensitive portion 7. The incident infrared radiation directed toward the other thin film thermosensitive portion 8 is intercepted by the infrared interception film 11. The differential output produced between the one thermosensitive portion 7 exposed to the incident infrared radiation and the other thin film thermosensitive portion 8 not exposed thereto is transferred via a flexible substrate (not shown) to a pertinent external tester. The periphery of the cavity 3 and that of the thin film thermosensitive portion 7 contained in an excavated portion is retained in a vacuumized state by having the lids (front lid 10 and rear lid 15) joined to the opposite sides of the silicon substrate 2 as a sensor substrate, with the rear lid 15 first joined to the lower side of the silicon substrate 2 and the front lid 10 subsequently joined in a vacuum to the upper side of the silicon substrate 2. Owing to this arrangement, the infrared radiation sensor enjoys increased sensitivity because the thin film thermosensitive portion 7 can be heated highly efficiently even with a very minute amount of infrared radiation without entailing the possibility of losing the energy of the incident infrared radiation through the medium of the ambient air. The other thin film thermosensitive portion 8 is likewise retained under the same vacuumized state. Thus, the true amount of infrared radiation can be detected based on the differential output between these two thermosensitive portions 7 and 8.

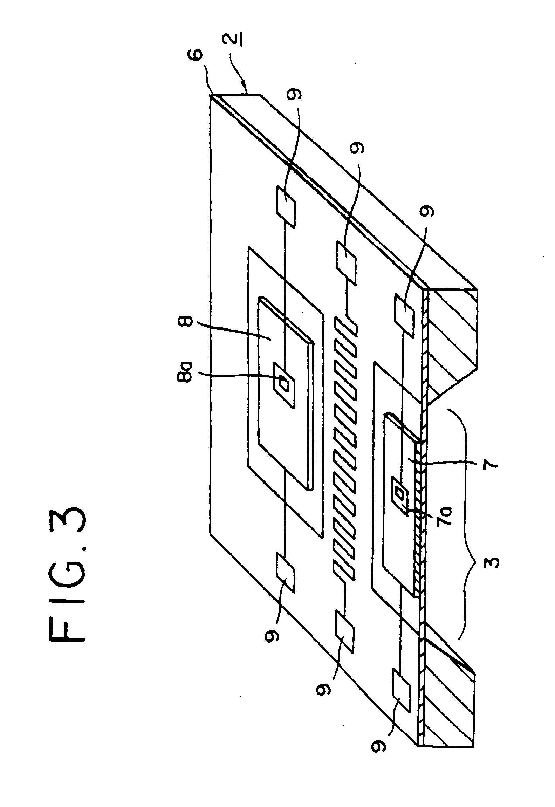

As regards the shape (construction) of the insulating thin film formed on the cavity of the sensor substrate, the diaphragm type and the cantilever type are conceivable besides the type shown in the present embodiment. The schematic diagrams which depict these types in a simplified pattern are given as Fig. 3 through Fig. 6.

First, Fig. 3 is a diagram schematically illustrating a partially sectioned construction of a sensor substrate having a thin film formed in the diaphragm construction therein. In the diaphragm type construction of Fig. 3, a thin film of silicon oxynitride is formed as an insulating thin film superposed on the cavity formed in the sensor substrate throughout the entire area thereof. In this diagram, like portions to those found in Fig. 2 are denoted by like reference numerals. Specifically, the reference numeral 2 stands for a silicon substrate as a sensor substrate, 3 for a cavity, 6 for a silicon oxynitride film, 7 and 8 each for a thin film thermosensitive portion, 7a and 8a are Schottky junctions, and 9 for an electrode pad.

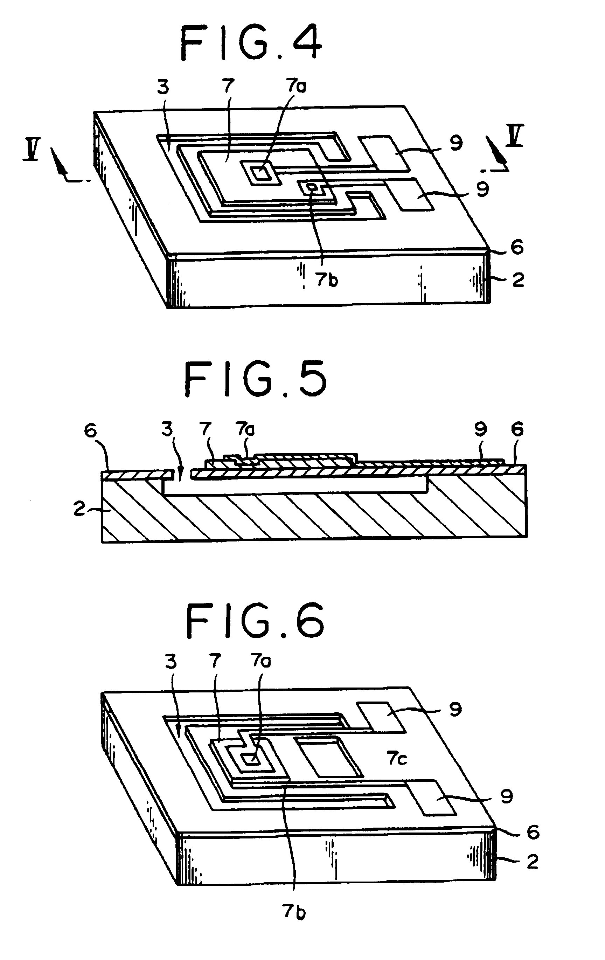

Fig. 4 is a diagram schematically illustrating a sensor substrate having a thin film of the cantilever type construction formed thereon. Fig. 5 is a simplified diagram illustrating a cross section taken through Fig. 4 along the V-V line. It is remarked from Fig. 4 and Fig. 5 that a thin film of silicon oxynitride is formed as an insulating thin film of the cantilever type construction supported at one end as laid over the cavity 3 formed in the sensor substrate 2. In this construction, the thin film does not need to be either superposed on the cavity 3 throughout the substantially entire area thereof or bridged as supported at the opposite ends as in the bridge construction. In this diagram, like portions to those found in Fig. 2 are denoted by like reference numerals. Specifically, the reference numeral 2 is a silicon substrate as a sensor substrate, 3 is a cavity, 6 is a silicon oxynitride film, 7 (and 8) is a thin film thermosensitive portion, 7a is Schottky junction, 7b is an ohmic electrode, and 9 is an electrode pad.

Fig. 6 shows another embodiment of the present invention having a cantilever type construction wherein a thin film of silicon oxynitride film is formed as an electrical insulating thin film which is supported at one end on the cavity 3 which is formed in the sensor substrate 2 similar to the case of Figs. 4 and 5. A hole 7c is formed in the cantilever type thin film and radiation of heat is substantially prevented. Further, in this diagram, like portions to those found in Fig. 2 are denoted by like reference numerals. Specifically, the numeral 2 is a silicon substrate as a sensor substrate, 3 is a cavity, 6 is a silicon nitride film, 7 (and 8) is a thin film thermosensitive film, 7a is Schottky junction, 7b is an ohmic electrode, and 9 is an electrode pad.

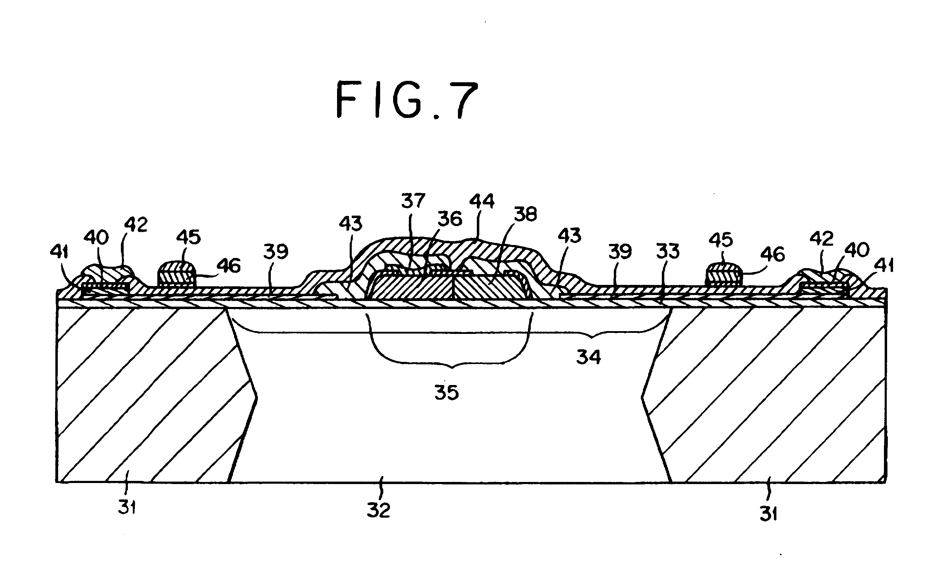

Fig. 7 is a schematic diagram illustrating in cross section (the cross section taken through Fig. 2 along the line VII-VII) a four-point support bridge construction of an insulating thin film superposed on a cavity formed in a sensor substrate including an infrared thermosensitive portion using a Schottky junction in the infrared radiation sensor in an embodiment of this invention.

In the construction of Fig. 7, a sensor substrate 31 is a single crystal silicon substrate having a thickness of 300µm and a face orientation (100). In this sensor substrate 31, a cavity 32 is formed by etching as described specifically hereinbelow. A bridge portion 34 having a silicon oxynitride film 33 as a component member thereof is formed across the cavity 32 (actually bridged as supported at four points). In the substantially central portion of the bridge portion 34, a thin film thermosensitive portion 35 of polycrystalline silicon about 1µm in thickness is disposed. A Schottky junction is formed in the interface between a portion 36 having phosphorus (P) ion injected at a low concentration (dosage: 1 × 10¹² cm⁻²) into polycrystalline silicon and metallic molybdenum (or molybdenum silicide) 37 formed by sputtering. The present invention comprises in utilizing as a thermosensitive element the Schottky junction, namely the temperature dependency of the reverse-direction current of a Schottky diode. Nearly one half of the polycrystalline silicon is transformed, by having phosphorus ions injected therein at a high concentration (dosage: not less than 1 × 10¹⁶ cm⁻²), into an n⁺ silicon 38 which forms an ohmic junction with an aluminum electrode.

In the present embodiment, the infrared thermosensitive portion 35 is superposed on the bridge construction for the purpose of decreasing the amount of heat diffused from the thermosensitive portion 35 into the ambience to the fullest possible extent. Then, for the purpose of widening the area which is assigned for the reception of the infrared radiation, the bridge portion 34 of Fig.7 is formed, in the same manner as the bridge portions 4 and 5, to have centralportions (diameter: about 1 mm) which are allowed to occupy a large area for seating theinfrared receiving portions 13 thereon as illustrated in Fig.2. Further, portions of the silicon oxynitride film 33 of Fig.7 are formed such that the central portions are suspended by bridge members 16 of a slender shape (10 µm or 20 µm in width) as illustrated in Fig. 2, for the purpose of decreasing the amount of heat to be diffused through the bridge members 16 to the fullest possible extent.

The electric wiring from the infrared thermosensitive portion made of a Schottky diode is formed of a thin film chromium layer 39 (Cr) superposed on the bridge portion 34 so as to minimize the heat-conductivity. In the opposite terminal portions of the chromium layer 39, a titanium layer 40 (Ti) and a copper layer 41 (Cu) are vacuum deposited (sequentially downward in the order mentioned) on the chromium layer 39 so as to afford contact pads for an external electric wiring. Further, gold 42 (Au) is deposited or plated on the surface of the titanium layer 40.

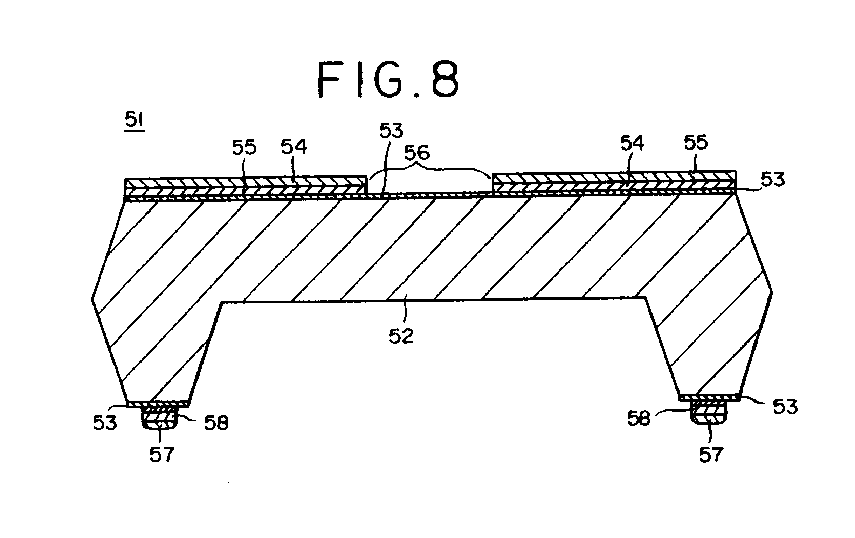

Between the infrared thermosensitive portion and the chromium wiring, an aluminum layer 43 (about 1.5µm in thickness) is deposited by the sputtering technique of suitable step coverage so as to provide interconnection therefor. For the purpose of protecting the thermosensitive portion 35 and the electric wiring against the hydrazine solution which is used for etching the silicon substrate and forming the cavity 32 therein, a silicon oxynitride film 44 is deposited in a thickness of 3µm on the substantially entire composite in process of production after the aluminum layer 43 has been formed and patterned. As a stock for soldering this silicon oxynitride film 44 to a front lid (51) illustrated in Fig. 8, a copper layer 45 and a titanium layer 46 are superposed on the silicon oxynitride film 44 sequentially downward in the order mentioned by vacuum deposition.

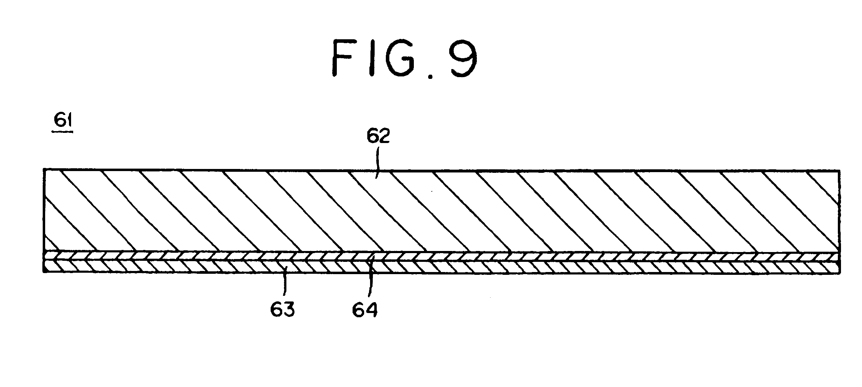

Incidentally, a silicon oxynitride film (not shown) is deposited preparatorily on the lower side of the sensor substrate 31. This film is so adapted as to expose the silicon in the process of production for the purpose of permitting anodic fusion of the sensor substrate 31 and a glass substrate (62) of a rear lid (61) as illustrated in Fig. 9.

Fig. 8 is a cross section schematically illustrating one typical example of a front lid corresponding to the sensor substrate of Fig. 7. In the present embodiment, a single crystal silicon substrate 52 having a thickness of 300 µm and a face orientation (100) is used as the material for the front lid 51. On the opposite sides of the silicon substrate 52, silicon oxide films 53 having a thickness of 0.1 µm are formed one each as an infrared antireflection film concurrently serving as a mask for the anisotropic etching with hydrazine. On the silicon oxide film 53 constituting the side exposed to the incident infrared radiation (the upper side in the bearings of Fig. 8), metallic films 54 and 55 (superposition of copper and titanium) are formed. The portions of the metallic films 54 and 55 which exist directly above the infrared receiving portion (13) of the sensor substrate (31) are removed by etching to give rise to a window (aperture) 56 for admitting the incident infrared radiation. When this aperture 56 is provided with a fresnel lens, it is enabled to condense the incident infrared radiation on the infrared receiving portion (13) and heighten further the temperature of the thermosensitive portion (35). The Fesnel lens is formed by carrying on the silicon substrate 52 or by adhering the Fresnel lens film.

On the side of the front lid 51 opposed to the sensor substrate (31), a stock for soldering the front lid 51 to the sensor substrate (31) is formed. This soldering stock is formed of a superposed layers 57 and 58 of copper and titanium similarly to that which is formed on the sensor substrate (31) side.

The portion opposed to the bridge portion (34) is lowered by excavation to a depth of about 200 µm by anisotropic etching so as to keep the portion from contacting the component members formed on the bridge portion. At the same time that the lowered portion is formed, the silicon substrate 52 is excavated simultaneously from the obverse and the reverse sides thereof by anisotropic etching to attain separation thereof from adjacent chips. The chips are not completely severed but are serially connected with a thin silicon beam. They are separated asunder by dicing after they have been joined to sensor substrates (31). By this procedure, a multiplicity of chips can be aligned at once by the wafer process at the time of soldering.

Fig. 9 is a cross section schematically illustrating one typical example of a glass substrate destined to form a rear lid corresponding to the sensor substrate of Fig. 7. In this embodiment, a glass substrate 62 intended to form a rear lid 61 is made of Pyrex glass (trademark designation) 300 µm in thickness. The glass is kept exposed from the surface of the glass substrate 62 which is joined to the sensor substrate (31). The opposite surface of the glass substrate 62 has a copper layer 63 and a chromium layer 64 superposed thereon by vacuum deposition to intercept the visible and the infrared radiation.

Now, a typical procedure for assembling the sensor substrate, the junction means for a front lid and a rear lid, and the vacuum sealing means for use during the junction illustrated respectively in Fig. 7 through Fig. 9 sequentially in the order mentioned. First, the sensor substrate 31 shown in Fig. 7 and the glass substrate 62 of the rear lid 61 shown in Fig. 7 are joined by anodic fusion. This union is carried out in the open air. The atmosphere used for this union, therefore, is required to be thoroughly normal and perfectly free from defilement as with dust.

Then, the sensor substrate 31 already joined to the glass substrate 62 is grounded with a vacuum vessel provided with a heating mechanism and endowed with the function of an alignment. A wafer destined to form the front lid 51 is installed in the vacuum vessel. The vessel is thoroughly evacuated (to a vacuum pressure of not more than 10⁻⁶ Torr) and then the two substrates 31 and 51 are aligned to each other and soldered by heating. It is natural that the stocks for soldering the two substrates 31 and 51 be coated with solder in advance of the installation of the substrates in the vacuum vessel.

By the procedure described above, the infrared radiation sensor having the infrared thermosensitive portion and the bridge construction sealed therein in an atmosphere of vacuum can be manufactured.

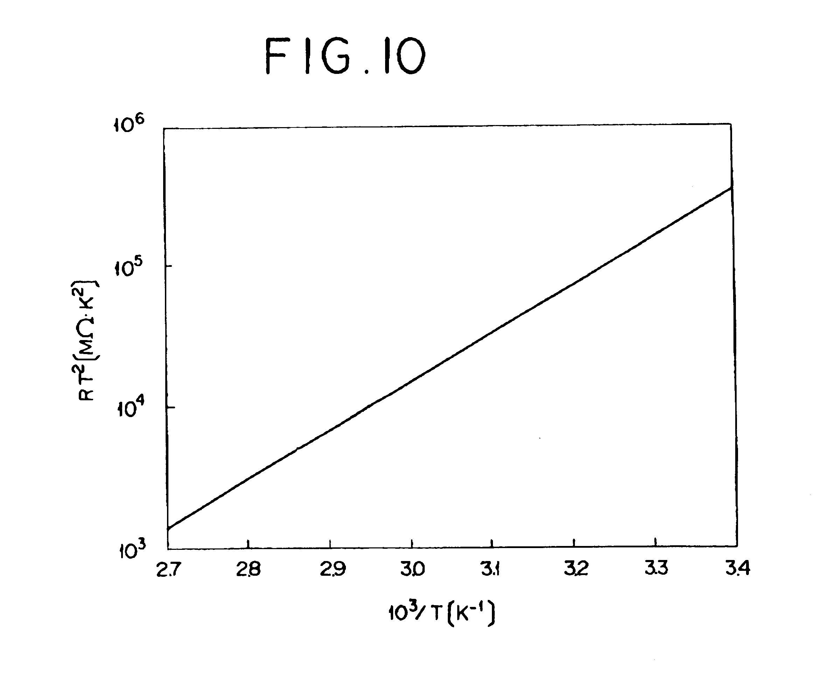

Fig. 10 is a graph showing the temperature characteristic of an infrared radiation sensor manufactured as one embodiment of the present invention by assembling the sensor substrate, the junction means for a front lid and a rear lid, and the vacuum sealing means for use during the junction illustrated respectively in Fig. 7 through Fig. 9 sequentially in the order mentioned. The equivalent thermistor constant of the Schottky diode is determined by applying a reverse bias voltage of 0.5 V to the Schottky diode and finding the change consequently caused in the temperature of the sensor by the reverse direction current. The equivalent thermistor constant obtained in the present embodiment is about 7250°C (7500 K), a magnitude more than two times that (about 3250°C (3500 K)) which is obtained by the conventional thermistor using germanium. Thus, it has been ascertained that this invention realizes a highly sensitive infrared radiation sensor.

## Claims

1. An infrared radiation sensor (1) which comprises a sensor substrate (2) containing a cavity (3) and having a thermosensitive portion (7) formed on an insulating thin film portion (6) superposed over said cavity (3), said thermosensitive portion (7) using a Schottky junction (7a) of a semiconductor thin film material and a metallic material, wherein said thermosensitive portion is operative, in response to a bias voltage applied thereto, to produce a reverse direction current that changes in correspondence with a change of temperature at the sensor caused by infrared radiation.

2. An infrared radiation sensor according to claim 1, wherein said Schottky junction (7a) is of a semiconducting thin film material and there is further provided vacuum sealing means (10, 15) covering the cavity (3) of the sensor substrate (2) and said thermosensitive portion and retaining the periphery of said thermosensitive portion (7) in vacuum.

3. An infrared radiation sensor according to claim 1 or 2, wherein said insulating thin film (6) offers insulation to heat.

4. An infrared radiation sensor according to claim 1 or 2, wherein said insulating thin film (6) is formed in a construction selected from among the bridge construction, the cantilever construction, and the diaphragm construction.

5. An infrared radiation sensor according to claim 1 or 2, wherein said insulating thin film (6) forms a bridge construction (4, 5).

6. An infrared radiation sensor according to claim 1 or 2, wherein said semiconductor material is polycrystalline silicon.

7. An infrared radiation sensor according to claim 1 or 2, wherein said semiconductor material is amorphous silicon.

8. An infrared radiation sensor according to claim 1 or 2, wherein said metallic material is molybdenum.

9. An infrared radiation sensor according to claim 1 or 2, wherein said metallic material is molybdenum silicide.

10. An infrared radiation sensor according to claim 2, wherein said sensor further comprises a Fresnel lens provided or formed in the injection of said vacuum sealing means (51).

11. A method of making an infrared radiation sensor (1), comprising the steps of:
i) preparing a sensor substrate (2);
ii) forming a cavity (3) in said substrate;
iii) forming an insulating thin film portion (6) superposed over said cavity (3); and
iv) forming, on said insulating thin film portion, a thermosensitive portion (7) comprising a Schottky junction (7a) of a semiconducting or thin film material and a metallic material wherein said thermosensitive portion is operative, in response to a bias voltage applied thereto, to produce a reverse direction current that changes in correspondence with a change of temperature at the sensor caused by infrared radiation.

12. The method according to claim 11, wherein said Schottky junction (7a) is of a semiconducting thin film material and further comprising the steps of providing vacuum sealing means (10, 15) covering the cavity (3) of the sensor substrate (2) and said thermosensitive portion and retaining the periphery of said thermosensitive portion (7) in a vacuum.

13. The method according to claim 11 or 12, wherein said insulating thin film (6) offers insulation to heat.

14. The method according to claim 11 or 12, wherein said insulating thin film (6) is formed in a construction selected from among the bridge construction, the cantilever construction and the diaphragm construction.

15. The method according to claim 11 or 12, wherein said insulating thin film (6) forms a bridge construction (4, 5).

16. The method according to claim 11 or 12, wherein said semiconductor material is polycrystalline silicon.

17. The method according to claim 11 or 12, wherein said semiconductor material is amorphous silicon.

18. The method according to claim 1 or 12, wherein said metallic material is molybdenum.

19. The method according to claim 11 or 12, wherein said metallic material is molybdenum silicide.

20. The method according to claim 12, further comprising the step of providing or forming a Fresnel lens provided or formed in the injection of said vacuum sealing means (51).

21. Use of an infrared radiation sensor (4) according to any one of claims 1 to 10, comprising :
applying to a reverse bias voltage to the Schottky junction of the thermosensitive portion (7), and
measuring the reverse direction current through the Schottky junction.

## Patentansprüche

1. Infrarot-Strahlungssensor (1), mit einem Sensor-substrat (2), das einen Hohlraum (3) aufweist und einen wärmeempfindlichen Abschnitt (7) hat, der auf einem dem Hohlraum (3) überlagerten isolierenden Dünnschichtabschnitt (6) ausgebildet ist, wobei der wärmeempfindliche Abschnitt (7) einen Schottkyübergang (7a) aus einem Halbleiter-Dünnschichtmaterial und einem metallischen Material verwendet, wobei der wärmeempfindliche Abschnitt im Ansprechen auf eine daran angelegte Vorspannung aktiv ist, um einen Strom in Sperrichtung zu erzeugen, der sich entsprechend einer durch Infrarot-Strahlung bedingten Temperaturänderung bei dem Sensor verändert.

2. Infrarot-Strahlungssensor nach Anspruch 1, wobei der Schottkyübergang (7a) ein halbleitendes Dünnschichtmaterial enthält und weiterhin Vakuumversiegelungseinrichtungen (10, 15) bereitgestellt sind, die den Hohlraum, (3) des Sensorsubstrats (2) und den wärmeempfindlichen Abschnitt umgeben und die Umgebung des wärmeempfindlichen Abschnitts (7) im Vakuum halten.

3. Infrarot-Strahlungssensor nach Anspruch 1 oder 2, wobei die isolierende Dünnschicht (6) wärmeisolierend ist.

4. Infrarot-Strahlungssensor nach Anspruch 1 oder 2, wobei die isolierende Dünnschicht (6) in einer Anordnung nach dem Brücken-, dem Ausleger-, oder dem Membranaufbau ausgebildet ist.

5. Infrarot-Strahlungssensor nach Anspruch 1 oder 2, wobei die isolierende Dünnschicht (6) einen Brückenaufbau (4,5) ausbildet.

6. Infrarot-Strahlungssensor nach Anspruch 1 oder 2, wobei das Halbleitermaterial polykristallines Silizium ist.

7. Infrarot-Strahlungssensor nach Anspruch 1 oder 2, wobei das Halbleitermaterial amorphes Silizium ist.

8. Infrarot-Strahlungssensor nach Anspruch 1 oder 2, wobei das metallische Material Molybdän ist.

9. Infrarot-Strahlungssensor nach Anspruch 1 oder 2, wobei das metallische Material Molybdänsilizid ist.

10. Infrarot-Strahlungssensor nach Anspruch 2, wobei der Sensor weiterhin eine in dem Einlaß der Vakuumversiegelungseinrichtung (51) bereitgestellte oder ausgebildete fresnellinse aufweist.

11. Verfahren zur Herstellung eines Infrarot-Strahlungssensors (1), das die Schritte
i) Vorbereiten eines Sensorsubstrats (2),
ii) Ausbilden eines Hohlraums (3) in dem Substrat,
iii) Ausbilden eines dem Hohlraum (3) überlagerten isolierenden Dünnschichtabschnitts (6) und
iv) Ausbilden eines wärmeempfindlichen Abschnitts (7) auf dem isolierenden Dünnschichtabschnitt aufweist, wobei der wärmeempfindliche Abschnitt (7) einen Schottkyübergang (7a) aus einem halbleitenden oder Dünnschichtmaterial und einem metallischen Material aufweist, wobei der wärmeempfindliche Abschnitt im Ansprechen auf eine daran angelegte Vorspannung aktiv ist, um einen Strom in Sperrichtung zu erzeugen, der sich entsprechend einer durch Infrarot-Strahlung bedingten Temperaturänderung bei dem Sensors verändernden.

12. Verfahren nach Anspruch 11, wobei der Schottkyübergang (7a) ein halbleitendes Dünnschichtmaterial enthält und das weiterhin die Schritte der Bereitstellung von Vakuumversiegelungseinrichtungen (10, 15) umfaßt, die den Hohlraum (3) des Sensorsubstrats (2) und den wärmeempfindlichen Abschnitt umgeben und die Umgebung des wärmeempfindlichen Abschnitts (7) im Vakuum halten.

13. Verfahren nach Anspruch 11 oder 12, wobei die isolierende Dünnschicht (6) wärmeisolierend ist.

14. Verfahren nach Anspruch 11 oder 12, wobei die isolierende Dünnschicht (6) in einer Anordnung nach dem Brücken-, dem Ausleger-, oder dem Membranaufbau ausgebildet ist.

15. Verfahren nach Anspruch 11 oder 12, wobei die isolierende Dünnschicht (6) einen Brückenaufbau (4,5) ausbildet.

16. Verfahren nach Anspruch 11 oder 12, wobei das Halbleitermaterial polykristallines Silizium ist.

17. Verfahren nach Anspruch 11 oder 12, wobei das Halbleitermaterial amorphes Silizium ist.

18. Verfahren nach Anspruch 11 oder 12, wobei das metallischen Material Molybdän ist.

19. Verfahren nach Anspruch 11 oder 12, wobei das metallische Material Molybdänsilizid ist.

20. Verfahren nach Anspruch 12, das weiterhin den Schritt der Anordnung oder Ausbildung einer in dem Einlaß der Vakuumversiegelungseinrichtung (51) angeordneten oder ausgebildeten Fresnellinse aufweist.

21. Verwendung eines Infrarot-Strahlungssensors (4) nach einem der Ansprüche 1 bis 10, wobei
eine Sperrspannung an den Schottkyübergang des wärmeempfindlichen Abschnitts (7) angelegt wird und
der Sperrstrom durch den Schottkyübergang gemessen wird.

## Revendications

1. Capteur de rayonnement infrarouge (1) qui comprend un substrat de capteur (2) contenant une cavité (3) et comportant une partie thermosensible (7) formée sur une partie de film mince isolant (6) superposée au dessus de ladite cavité (3), ladite partie thermosensible (7) utilisant une jonction Schottky (7a) en un matériau de film mince semiconducteur et en un matériau métallique, dans lequel ladite partie thermosensible fonctionne, en réponse à une tension de polarisation qui lui est appliquée, pour produire un courant en sens inverse qui varie en correspondance avec une variation de température au niveau du capteur produite par un rayonnement infrarouge.

2. Capteur de rayonnement infrarouge selon la revendication 1, dans lequel ladite jonction Schottky (7a) est en un matériau de film mince semiconducteur, et il est en outre prévu un moyen d'étanchéité au vide (10, 15) qui recouvre la cavité (3) du substrat de capteur (2) et ladite partie thermosensible et qui retient la périphérie de ladite partie thermosensible (7) sous vide.

3. Capteur de rayonnement infrarouge selon la revendication 1 ou 2, dans lequel ledit film mince isolant (6) assure une isolation thermique.

4. Capteur de rayonnement infrarouge selon la revendication 1 ou 2, dans lequel ledit film mince isolant (6) est formé selon une construction choisie parmi la construction en pont, la construction en porte-à-faux et la construction en diaphragme.

5. Capteur de rayonnement infrarouge selon la revendication 1 ou 2, dans lequel ledit film mince isolant (6) forme une construction en pont (4, 5).

6. Capteur de rayonnement infrarouge selon la revendication 1 ou 2, dans lequel ledit matériau semiconducteur est du silicium polycristallin.

7. Capteur de rayonnement infrarouge selon la revendication 1 ou 2, dans lequel ledit matériau semiconducteur est du silicium amorphe.

8. Capteur de rayonnement infrarouge selon la revendication 1 ou 2, dans lequel ledit matériau métallique est du molybdène.

9. Capteur de rayonnement infrarouge selon la revendication 1 ou 2, dans lequel ledit matériau métallique est du siliciure de molybdène.

10. Capteur de rayonnement infrarouge selon la revendication 2, dans lequel ledit capteur comprend en outre une lentille de Fresnel prévue ou formée dans l'injection dudit moyen d'étanchéité au vide (51).

11. Procédé de fabrication d'un capteur de rayonnement infrarouge (1) comprenant les étapes de :
i) préparation d'un substrat de capteur (2) ;
ii) formation d'une cavité (3) dans ledit substrat ;
iii) formation d'une partie de film mince isolant (6) superposée au dessus de ladite cavité (3) ; et
iv) formation, sur ladite partie de film mince isolant, d'une partie thermosensible (7) comprenant une jonction Schottky (7a) en un matériau de film mince semiconducteur et en un matériau métallique, dans lequel ladite partie thermosensible fonctionne, en réponse à une tension de polarisation qui lui est appliquée, pour produire un courant en sens inverse qui varie en correspondance avec une variation de température au niveau du capteur produite par un rayonnement infrarouge.

12. Procédé selon la revendication 11, dans lequel ladite jonction Schottky (7a) est en un matériau de film mince semiconducteur, et comprenant en outre les étapes de constitution d'un moyen d'étanchéité au vide (10, 15) qui recouvre la cavité (3) du substrat de capteur (2) et ladite partie thermosensible et qui retient la périphérie de ladite partie thermosensible (7) sous vide.

13. Procédé selon la revendication 11 ou 12, dans lequel ledit film mince isolant (6) assure une isolation thermique.

14. Procédé selon la revendication 11 ou 12, dans lequel ledit film mince isolant (6) est formé selon une construction choisie parmi la construction en pont, la construction en porte-à-faux et la construction en diaphragme.

15. Procédé selon la revendication 11 ou 12, dans lequel ledit film mince isolant (6) forme une construction en pont (4, 5).

16. Procédé selon la revendication 11 ou 12, dans lequel ledit matériau semiconducteur est du silicium polycristallin.

17. Procédé selon la revendication 11 ou 12, dans lequel ledit matériau semiconducteur est du silicium amorphe.

18. Procédé selon la revendication 11 ou 12, dans lequel ledit matériau métallique est du molybdène.

19. Procédé selon la revendication 11 ou 12, dans lequel ledit matériau métallique est du siliciure de molybdène.

20. Procédé selon la revendication 12, comprenant en outre l'étape de constitution ou de formation d'une lentille de Fresnel constituée ou formée lors de l'injection dudit moyen d'étanchéité au vide (51).

21. Utilisation d'un capteur de rayonnement infrarouge (4) selon l'une quelconque des revendications 1 à 10, comprenant :
l'application d'une tension de polarisation inverse sur la jonction Schottky de la partie thermosensible (7) ; et
mesure du courant de sens inverse au travers de la jonction Schottky.
